# EUROPÄISCHE PATENTSCHRIFT

(11) **EP 1 190 610 B1**
(45) Veröffentlichungstag und Bekanntmachung des Hinweises auf die Patenterteilung: **22.09.2004**
(21) Anmeldenummer: 00934901.0
(22) Anmeldetag: 12.04.2000
(51) Int. Cl.: H05K 7/20

(54) **ANORDNUNG ZUM KÜHLEN EINER ELEKTRISCHEN BAUGRUPPE UND TECHNISCHES GERÄT**
DEVICE FOR COOLING AN ELECTRIC MODULE AND A TECHNICAL APPLIANCE
SYSTEME POUR REFROIDIR UN BLOC DE COMPOSANTS ET APPAREIL TECHNIQUE CORRESPONDANT

(30) Priorität: 13.04.1999 DE 19916595
(43) Veröffentlichungstag der Anmeldung: 27.03.2002
(73) Patentinhaber: SIEMENS AKTIENGESELLSCHAFT, 80333 München (DE)
(72) Erfinder: REECK, Guido, D-80469 München (DE); HOEFER, Bruno, D-82140 Olching (DE)
(86) Internationale Anmeldenummer: PCT/DE2000/001140
(87) Internationale Veröffentlichungsnummer: WO 2000/062589

(56) Entgegenhaltungen:
- EP-A1- 0 804 966
- DE-A1- 19 626 778
- US-A- 5 566 377

## Beschreibung

Die Erfindung betrifft eine Anordnung zum Kühlen einer in einem Gehäuse angeordneten elektrischen Baugruppe und ein technisches Gerät, insbesondere eine Basisstationen eines Mobilfunksystems oder drahtlosen Teilnehmeranschlußsystems.

In einem elektrisch betriebenen technischen Gerät führt die Verlustleistung stromdurchflossener Bauelemente und Baugruppen zu einer Erwärmung des Gerätes. Da elektrische Standardbauelemente für technische Geräte nur einen begrenzten zulässigen Betriebstemperaturbereich von beispielsweise bis zu 70°C aufweisen, werden diese durch Kühleinrichtungen gekühlt. Diese Kühleinrichtungen sind beispielsweise Ventilatoren, die in dem Gehäuse eine die elektrischen Bauelemente und Baugruppen um- bzw. durchströmende Luftströmung aufbauen und somit ein Abführen der erzeugten Wärmeleistung bewirken.

Bei einem Betrieb der technischen Geräte außerhalb geschlossener Räume oder in widrigen Verhältnissen innerhalb geschlossener Räume ist neben einer Wärmeabfuhr zusätzlich ein ausreichender Schutz vor Umwelteinflüssen wie beispielsweise Schmutzpartikeln und Flüssigkeiten vorzusehen. Hierbei müssen Schutzbestimmungen nach den spezifizierten IP-Klassen eingehalten werden, um eine dauerhafte Funktion der technischen Geräte sicherzustellen.

Aus der DE 19755944 ist bekannt, in einem Lufteinlaß eines Gehäuses einen Membranfilter für eine Oberflächenfilterung von Schmutzpartikeln aus einströmender Kühlluft und für ein Abscheiden von Flüssigkeiten vorzusehen. Im Vergleich zu einem beispielsweise aus der DE 19626778 bekannten Gehäuse mit einem Luft/Luft-Wärmetauscher, der eine vollständige Trennung eines inneren Kühlkreislaufes von einem äußeren Kühlkreislauf sicherstellt, kann durch den Einsatz des Membranfilters in einfacher Weise ein ausreichender Schutz der elektrischen Baugruppen für die oben genannten Einsatzgebiete des technischen Gerätes mit den entsprechenden Schutzbestimmungen erreicht werden. Gleichzeitig wird eine für die Kühlung benötigte Temperaturdifferenz zwischen der Temperatur der Umgebungsatmosphäre und der Temperatur im Inneren des Gehäuses verringert.

Ein derartiger Membranfilter basiert beispielsweise auf einer unter der Bezeichnung Goretex, Sympatex etc. für die Anwendung in Bekleidungsgegenständen bekannten Membran. Diese Membran besteht aus einem feinen Geflecht oder Gewirk von Fasern, das eine sehr kleine Porengröße ermöglicht. Als Material wird hierfür beispielsweise PTFE (Polytetrafluorethylen), auch unter dem Namen Teflon bekannt, verwendet. Die Membran wird in der Regel auf einem Trägermaterial wie beispielsweise Polyamid verwirklicht, um eine bestimmte Stabilität und Resistenz des Membranfilters zu erreichen.

Durch die sehr kleine Porengröße des Membranfilters ist dieser im Vergleich zu herkömmlichen Filtern verschmutzungsresistenter, da beispielsweise Schmutzpartikel sich nicht in dem Gewirk der Membran festsetzen können und an der Oberfläche des Filters abgeschieden werden. Trotz dieser Eigenschaft lagern sich an der Oberfläche des Membranfilters Schmutzparktikel ab und bilden einen sogenannten Filterkuchen, der für die Kühlluft einen zusätzlich zu überwindenden Widerstand darstellt. Nachteilig kann sich dieser Filterkuchen hinsichtlich einer Minimierung des Kühlluftdurchsatzes aufgrund des gestiegenen Gegendruckes und eines daraus folgenden Überschreitens der zulässigen Grenztemperatur auswirken.

Der Erfindung liegt die Aufgabe zugrunde, eine Anordnung zum Kühlen und ein technisches Gerät anzugeben, die eine einfache Reinigung des Membranfilters ermöglichen. Diese Aufgabe wird durch die Anordnung zum Kühlen nach Patentanspruch 1 und das technische Gerät nach Patentanspruch 12 gelöst. Vorteilhafte Weiterbildungen der Erfindung sind den Unteransprüchen zu entnehmen.

Die erfindungsgemäße Anordnung zum Kühlen einer in einem Gehäuse angeordneten elektrischen Baugruppe weist zumindest einen in jeweils einem Lufteinlaß des Gehäuses angeordneten Membranfilter für zumindest eine Oberflächenfilterung von Schmutzpartikeln aus einströmender Kühlluft zum Kühlen der elektrischen Baugruppe sowie zumindest eine Kühleinrichtung zum Aufbauen einer Luftströmung in dem Gehäuse und zum Herausführen der gefilterten, aufgrund eines Durch- und/oder Umströmens der Baugruppe erwärmten Kühlluft aus zumindest einen Luftauslaß aus dem Gehäuse auf. Kennzeichnend wird der Membranfilter mittels zumindest eines Schwingungserzeugers in eine mechanische Schwingung versetzt, die ein Ablösen der an der Oberfläche des Membranfilters abgelagerten Schmutzpartikel bewirkt.

Die Ausgestaltung der erfindungsgemäßen Anordnung besitzt den Vorteil, daß der Membranfilter durch die erzeugte mechanische Schwingung in einfacher Weise von den an der Oberfläche abgelagerten Schmutzpartikeln befreit wird, in dem der Filterkuchen praktisch abgeschüttelt werden.

Gemäß einer ersten Ausgestaltung der Erfindung scheidet der Membranfilter zusätzlich Flüssigkeiten an der Oberfläche ab, wodurch ein Einsatz des technischen Gerätes auch außerhalb geschlossener Räume bzw. unter widrigen Umgebungsbedingungen möglich ist.

Gemäß einer weiteren Ausgestaltung der Erfindung weist die erzeugte mechanische Schwingung eine Frequenz auf, die einer Eigenresonanzfrequenz des Membranfilters entspricht. Diese Frequenz bewirkt eine mechanische Bewegung des Membranfilters mit einer größtmöglichen Amplitude, wodurch vorteilhaft eine effektivere Reinigung des Membranfilters erreicht wird.

Der Schwingungserzeuger kann gemäß vier alternativen Ausgestaltungen als ein elektrodynamischer Wandler, als ein elektromagnetischer Wandler, als ein elektromechanischer Wandler oder als ein elektrostatischer Wandler verwirklicht sein.

Bei den ersten drei alternativen Ausgestaltungen wird der Membranfilter mechanisch mit einem elektromechanischen, elektromagnetischen Wandler gekoppelt, der mechanische Schwingungen erzeugt. Hierbei kann beispielsweise auch ein Rahmen, in dem der Membranfilter befestigt ist, in eine mechanische Schwingung gesetzt werden, wobei in jedem Fall sichergestellt werden muß, daß Schmutzpartikel oder Flüssigkeit beispielsweise durch aufgrund der Schwingung entstehende Spalte oder Öffnungen nicht in das Gehäuse eindringen können.

Der elektromechanische Wandler kann gemäß einer Weiterbildung beispielsweise als ein piezoelektrischer Wandler verwirklicht sein.

Bei der vierten alternativen Ausgestaltung ist der Membranfilter zwischen zwei Kondensatorplatten angeordnet, wobei eine elektrostatische Kraft zwischen den Kondensatorplatten die mechanische Bewegung des Membranfilters bewirkt. Der Membranfilter muß dabei ganz oder teilweise aus einem elektrisch leitfähigen Material verwirklicht sein.

Gemäß einer Weiterbildung der vierten alternativen Ausgestaltung sind die Kondensatorplatten aus einem elektrisch leitfähigen Geflecht verwirklicht. Dieses Geflecht bewirkt vorteilhaft keine Einschränkung des Kühlluftdurchsatzes und kann für eine elektromagnetische Abschirmung sowie einen zusätzlichen Schutz des Membranfilters vor Umwelteinflüssen verwendet werden.

Gemäß einer auf die vorangehenden Ausgestaltungen rückbezogenen Weiterbildung ist der Membranfilter aus einem elektrisch leitfähigen Material als eine Kondensatorplatte verwirklicht, wodurch vorteilhaft der mechanische Aufbau vereinfacht wird.

Gemäß einer weiteren Ausgestaltung der erfindungsgemäßen Anordnung steuert eine Steuereinrichtung periodisch und/oder abhängig von einem Verschmutzungsgrad des Membranfilters den Schwingungserzeuger für die Reinigung des Membranfilters. Die Steuereinrichtung steuert den Schwingungserzeuger beispielsweise abhängig von einer notwendigen Drehzahl der als ein Ventilator ausgestalteten Kühleinrichtung. Dabei kann unter Berücksichtigung des Temperaturunterschieds zwischen der Außenatmosphäre und dem Inneren des Gehäuse der benötigte Kühlluftdurchsatz ermittelt werden. Ist eine Erhöhung der Drehzahl des Ventilators um einen bestimmten Faktor notwendig, um den gleichen Kühlluftdurchsatz zu erreichen, bzw. unterschreitet der Kühlluftdurchsatz bei einer konstanten Drehzahl des Ventilators einen bestimmten Schwellwert, kann auf einen bestimmten Verschmutzungsgrad des Membranfilters geschlossen und ein Reinigungsvorgang durch die Steuereinrichtung initiiert werden. Weiterhin kann ein Reinigungsvorgang durch eine Druckmessung im Inneren des Gehäuses, beispielsweise durch einen Druckdifferenzschalter gesteuert, initiiert werden. Hierbei wird permanent oder periodisch der Druck in dem Gehäuse gemessen und mit einem Schwellwert verglichen. Unterschreitet der gemessene Druck diesen Schwellwert, wird von der Steuereinrichtung der Reinigungsvorgang initiiert. Neben diesen dynamischen Ansteuerungen des Reinigungsvorgangs kann der Reinigungsvorgang auch periodisch, beispielsweise durch einen Timer in der Steuereinrichtung gesteuert, erfolgen. Die Reinigung des Membranfilters kann somit in einfacher Weise außerhalb der normalen Wartungsintervalle des technischen Gerätes von abgelagerten Schmutzpartikeln befreit werden.

Die Steuereinrichtung kann weiterhin beispielsweise die Frequenz der in dem Schwingungserzeuger erzeugten Schwingung steuern.

Die erfindungsgemäße Anordnung kann in technischen Geräten mit zumindest einer elektrischen Baugruppe wie beispielsweise Basisstationen eines Mobilfunksystems oder drahtlosen Teilnehmeranschlußsystems (Access-Network-Systems), Verkehrsleiteinrichtungen, Versorgungseinrichtungen oder Schaltschränken für eine Steuerung von industriellen Maschinen eingesetzt werden. In gleicher Weise kann die erfindungsgemäße Anordnung beispielsweise in kleineren elektrischen Geräten wie beispielsweise einem tragbaren bzw. stationären Heimcomputer oder in elektrischen Meßgeräten eingesetzt werden.

Ausführungsbeispiele der Erfindung werden anhand der beiliegenden Zeichnungen näher erläutert.

Dabei zeigen
- FIG 1: eine Basisstation eines Mobilfunksystems mit der erfindungsgemäßen Anordnung zum Kühlen von elektrischen Baugruppen in einer Seitenansicht,
- FIG 2: die erfindungsgemäße Anordnung mit einer Beaufschlagung des Membranfilters mit Druckwellen,
- FIG 3: die erfindungsgemäße Anordnung mit einem elektrostatischen Wandler in einer Seitenansicht, und
- FIG 4: eine Vorderansicht der erfindungsgemäßen Anordnung der FIG 1 bis FIG 3.

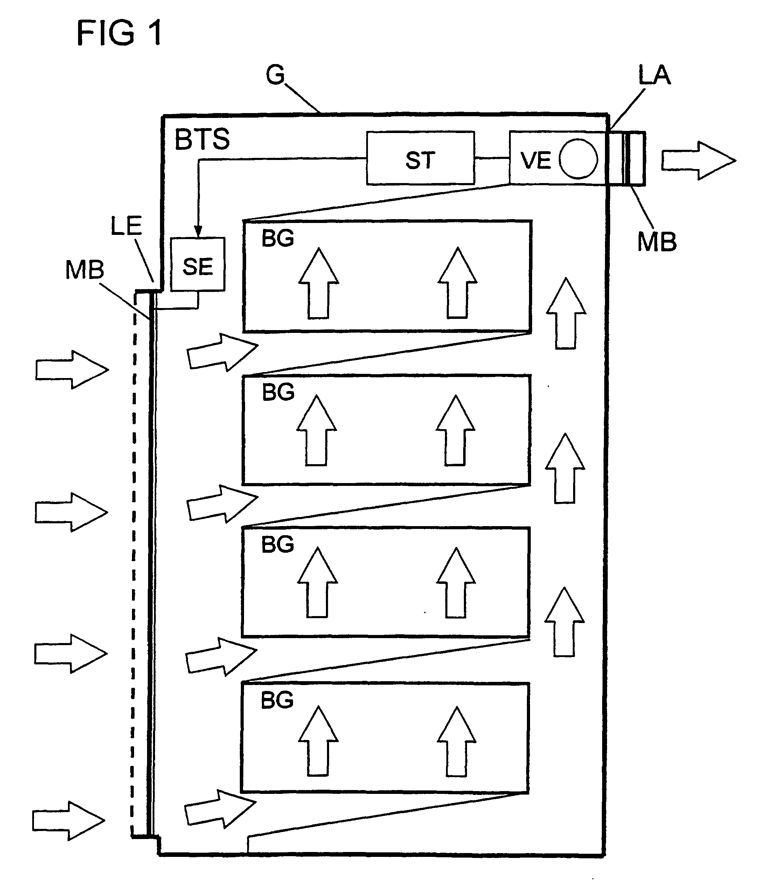

Ein technisches Gerät, wie beispielsweise eine Basisstation BTS eines Mobilfunksystems oder drahtlosen Teilnehmeranschlußsystems, nach dem Stand der Technik gemäß FIG 1 enthält eine oder mehrere elektrische Baugruppen BG. Während des Betriebes des elektrischen Gerätes führt die Verlustleistung der einzelnen elektrischen Baugruppen BG zu einer Erwärmung, wodurch die Notwendigkeit einer Kühlung entsteht, um eine maximal zulässige Betriebstemperatur der Baugruppen BG oder einzelner elektrischer Bauelemente nicht zu überschreiten.

Das in einer Seitenansicht dargestellte Gehäuse G eines elektrischen Gerätes weist an einer Stirnseite einen Lufteinlaß LE mit einem Membranfilter MB auf. Die Ausmaße des Lufteinlasses LE sind dabei beispielsweise derart dimensioniert, daß durch den Membranfilter MB einströmende Kühlluft aus der Umgebungsatmosphäre des technischen Gerätes die elektrischen Baugruppen BG jeweils von unten und gegebenenfalls von vorne durchströmen kann und somit ein Abkühlen der Baugruppen BG bzw. der elektrischen Bauelemente auf den Baugruppen BG bewirkt. Die aktive Oberfläche des Membranfilters MB, welche beispielsweise durch eine Faltenbildung größer als der Lufteinlaß LE sein kann, ist so dimensioniert, daß der Druckabfall der einströmenden Kühlluft durch eine Kühleinrichtung VE kompensiert werden kann bzw. trotz eines teilweisen Zusetzens des Membranfilters MB durch Schmutzpartikel oder Flüssigkeit noch eine ausreichende Menge Kühlluft einströmen kann. Für eine Erfüllung von Bestimmungen hinsichtlich der elektromagnetischen Verträglichkeit ist vor dem Membranfilter MB beispielsweise ein Drahtgeflecht angeordnet, das elektrisch mit dem Gehäuse G des technischen Gerätes verbunden ist. Dieses Drahtgeflecht kann gleichzeitig auch einen mechanischen Schutz des Membranfilters MB vor Umwelteinflüssen darstellen.

Durch eine zueinander beabstandete Anordnung der Baugruppen BG wird eine Durchströmung bzw. Umströmung der Baugruppen BG ermöglicht. Nach einer bekannten Bauart bestehen die Baugruppen BG beispielsweise aus einem Einschubgehäuse mit darin befindlichen elektronischen Bauelementen und Hochleistungsschaltkreisen. Die Einschubgehäuse sind mit Lüftungsschlitzen ausgestattet, durch die Kühlluft zu den Bauelementen und Schaltkreisen gelangen kann. Unter Baugruppen BG werden im Umfang der Erfindung weiterhin alle elektrischen Einrichtungen eines technischen Gerätes verstanden. So sind hierzu beispielsweise in einem Personal-Computer verwirklichte Leiterplatten sowie Peripherieeinheiten wie beispielsweise Festplatten zu zählen.

Die Anordnung der FIG 1 weist in den Räumen zwischen den einzelnen Baugruppen BG sowie unter der untersten und über der obersten Baugruppe BG Luftleiteinrichtungen auf, die die Aufgabe besitzen, durch den Membranfilter MB einströmende Kühlluft gleichmäßig über die Grundfläche der jeweiligen Baugruppe BG zu verteilen, so daß es zu einer homogenen Durchströmung der gesamten Baugruppe BG kommt. Weiterhin können die Luftleiteinrichtungen zur gegenseitigen elektromagnetischen Abschirmen der Baugruppen BG in Hinblick auf die Erfüllung der EMV-Bestimmungen verwendet werden.

Der Membranfilter MB ist beispielsweise in einem Rahmen angeordnet, der eine schnelle Herausnahme der aus dem Membranfilter und dem Rahmen bestehenden Membranfilterkassette zu Wartungs- und Reinigungszwecken bzw. zum Austausch ermöglicht. Gleichzeitig ermöglicht der Rahmen eine beschriebene Faltung des Membranfilters MB. Der Rahmen kann zur Beschränkung der Ausmaße des technischen Gerätes auch in das Gehäuse G integriert werden.

Der Membranfilter MB ist als ein Oberflächenfilter ausgeführt, der die besonders vorteilhafte Eigenschaft besitzt, Schmutzpartikel und Flüssigkeiten der Umgebungsatmosphäre bereits an der Oberfläche der Membran abzuscheiden, wodurch beispielsweise empfindliche elektronische Bausteine oder Schaltungen in den Baugruppen BG gegen derartige Umwelteinflüsse geschützt werden. Ein derartiger Membranfilter MB basiert beispielsweise auf einer unter der Bezeichnung Goretex, Sympatex etc. für die Anwendung in Bekleidungsgegenständen bekannten Membran. Die Membran des Filters besteht aus einem feinen Geflecht oder Gewirk von Fasern. Eine sehr kleine Porengröße verhindert ein Eindringen der Schmutzpartikel und somit ein irreversibles Zusetzen der Membran. Gleichwohl können sich an der Oberfläche der Membran Schmutzpartikel zu einem sogenannten Filterkuchen ablagern, der jedoch durch die erfindungsgemäße Anordnung in einfacher Weise entfernt werden kann. In gleicher Weise können Flüssigkeiten bis zu einem speziellen Druck pro Flächeneinheit die Membran nicht passieren. Als Material wird für die Membran beispielsweise PTFE, auch unter dem Namen Teflon bekannt, verwendet. Die Membran wird in der Regel auf einem grob gewebten Trägermaterial wie beispielsweise Polyamid aufgetragen, um eine hohe Stabilität und Resistenz des Membranfilters MB zu erreichen.

Durch eine spezielle Auslegung des Membranfilters MB können Schutzbestimmungen nach den IP-Richtlinien bis beispielsweise IP55 erfüllt werden, wodurch ein Einsatz des technischen Gerätes außerhalb geschlossener Räume bzw. unter widrigen Umgebungsbedingungen, wie sie beispielsweise bei der industriellen Produktion auftreten, ermöglicht wird. Durch eine spezielle Auswahl des Membranfiltermaterials kann darüber hinaus eine individuelle Anpassung an die realen Umweltbedingungen, wie beispielsweise eine Resistenz gegen Säuren, erfolgen.

Die Kühlung der elektrischen Baugruppen BG durch eine direkte Durchströmung des Gehäuses G mit Kühlluft besitzt den Vorteil einer gegen Null tendierenden notwendigen Temperaturdifferenz zwischen der Temperatur der Umgebungsatmosphäre bzw. der Temperatur der einströmenden Kühlluft und der Temperatur im Inneren des Gehäuses G, wodurch der Betrieb der elektrischen Baugruppen BG auch bei einer Temperatur der Umgebungsatmosphäre von beispielsweise +70°C, die der Grenztemperatur der Bauelemente entspricht, vermindert um den Grad der inneren Erwärmung, gesichert ist.

Eine Kühlanordnung VE, die beispielsweise in dem oberen Bereich der rückseitigen Gehäusewand angeordnet ist, saugt die bei der Durch- bzw. Umströmung der elektrischen Baugruppen BG erwärmte Luft an und führt sie durch einen Luftauslaß LA an die Umgebungsatmosphäre ab. Als Kühleinrichtungen VE werden beispielsweise ein oder mehrere Ventilatoren eingesetzt, die ein Luftströmung erzeugen. Eine Kühlung mittels einer natürlichen Konvektion ist für einen sicheren Betrieb der Baugruppen BG unterhalb der Grenztemperatur nicht ausreichend, wenn aufgrund einer hohen internen Verlustleistung eine starke Erwärmung der Baugruppen BG auftritt. Der Luftauslaß LA kann ebenfalls durch einen Membranfilter MB gegen ein Eindringen von Flüssigkeiten und Schmutzpartikeln geschützt werden.

Zur Regelung der Temperatur im Inneren des Gehäuses G wird die Drehzahl des Ventilators durch eine Steuereinrichtung ST geregelt. Zur Erfassung von Parametern für diese Regelung können beispielsweise in dem Bereich des Lufteinlasses LE, des Luftauslasses LA sowie an verschiedenen Stellen innerhalb des Gehäuses G Temperaturfühler vorgesehen werden, die permanent die Temperaturen der einströmenden Kühlluft und der Atmosphäre im Inneren des Gehäuses G bzw. die Temperatur von speziellen Bauelementen ermitteln, und die von der Steuereinrichtung ST ausgewertet werden. Bei dieser Regelung wird durch die Drehzahl des Ventilators der Kühleinrichtung VE der Durchsatz der Kühlluft in dem Gehäuse G verändert, um beispielsweise eine konstante Temperatur im Inneren des Gehäuses G unabhängig von der Temperatur der Umgebungsatmosphäre zu erhalten. Eine konstante Betriebstemperatur der Baugruppen BG wirkt sich beispielsweise positiv auf die Betriebsdauer von elektrischen Bauelementen und Hochleistungsschaltkreisen aus. Zusätzlich ermöglicht eine stets niedrig gehaltene Drehzahl der Kühleinrichtung VE, unter der Bedingung, daß die Grenztemperatur der Bauelemente nicht überschritten wird, eine Minimierung der Geräuschemission des technischen Gerätes. Weiterhin kann durch die Regelung bei einem Kaltstart des Gerätes anfangs von dem Betrieb der Kühleinrichtung VE abgesehen werden, um die Baugruppen BG schnell auf die gewünschte Betriebstemperatur erwärmen zu lassen und erst nach Erreichen dieser Betriebstemperatur eine weitere Regelung der Kühleinrichtung VE zum Beibehalten der konstanten Betriebstemperatur durchzuführen.

Durch die beim Betrieb des technischen Gerätes permanent durch den Membranfilter MB einströmende Kühlluft lagern sich an der Oberfläche des Membranfilters MB Schmutzpartikel ab, die zu einer Einschränkung des Kühlluftdurchsatzes führen können. Aufgrund der speziellen Eigenschaften des Membranfilters MB werden, wie beschrieben, die Schmutzpartikel an der Oberfläche des Filters abgeschieden. Durch die Tatsache, das die Schmutzpartikel nicht in den Filter eindringen und sich festsetzen können, kann dieser durch die nachfolgend beschriebenen erfindungsgemäßen Anordnungen in einfacher Weise von den an der Oberfläche abgelagerten Schmutzpartikeln befreit werden.

Ein Reinigungsvorgang des Membranfilters MB kann beispielsweise durch eine permanente Messung des Luftdurchsatzes in Abhängigkeit von der Drehzahl der Kühlanordnung VE bei einem Unterschreiten eines fest vorgegebenen Wertes initiiert werden, wobei das gemessene Verhältnis den Grad der Verschmutzung des Membranfilters MB angibt. Der Luftdurchsatz wird beispielsweise durch eine in dem Luftauslaß LA angeordnete Luftdurchsatzmeßeinrichtung gemessen und von der Steuereinrichtung ST ausgewertet. Eine weitere Möglichkeit ist eine permanente oder periodische Druckmessung in dem Gehäuse, beispielsweise durch einen Druckdifferenzschalter, der einen aktuell bestimmten Druck mit einem vorgegebenen Schwellwert vergleicht und bei einem Unterschreiten dieses Schwellwertes ein Signal zu der Steuereinrichtung sendet. Bei einer bestimmten Einschränkung des Kühlluftdurchsatzes durch den Membranfilter MB fördert die Kühleinrichtung VE beispielsweise eine große Menge Kühlluft aus dem Gehäuse G heraus als durch den Lufteinlaß LE in das Gehäuse G einströmen kann, wodurch ein Unterdruck in dem Gehäuse G entsteht. Nach Auswertung dieses Signals initiiert die Steuereinrichtung ST den Reinigungsvorgang. In gleicher Weise kann der Reinigungsvorgang beispielsweise durch einen Timer gesteuert in periodischen Zeitabständen von der Steuereinrichtung ST initiiert werden.

Die Steuereinrichtung ST steuert nach der Auswertung der genannten Parameter bzw. nach Ablauf eines vorgegebenen Zeitintervalls einen Schwingungserzeuger SE an, der den Membranfilter MB erfindungsgemäß in eine mechanische Schwingung versetzt. Die mechanische Bewegung des Membranfilters MB bewirkt ein Aufbrechen und Ablösen des abgelagerten Filterkuchens bestehend, wodurch ein Reinigungseffekt erzielt wird. Dieser automatische Reinigungsvorgang besitzt den Vorteil gegenüber einer Reinigung des Membranfilters MB beispielsweise im Rahmen einer Wartung des technischen Gerätes, daß einerseits die Wartungsintervalle verlängert werden können, andererseits die Betriebskosten des technischen Gerätes aufgrund einer optimalen Betriebsweise sowohl der Kühleinrichtung VE als auch der Baugruppen BG verringert werden können.

Erfindungsgemäß kann der Schwingungserzeuger SE als eine Vielzahl alternativer Wandlereinrichtungen verwirklicht sein. In der FIG 1 ist der Schwingungserzeuger SE beispielsweise ein elektromagnetischer, elektrodynamischer oder elektromechanischer Wandler, der jeweils mechanisch mit dem Membranfilter MB oder mit einem Rahmen, in dem der Membranfilter MB angeordnet ist, gekoppelt ist.

Der elektromagnetische Wandler kann beispielsweise als ein bekannter Elektromotor ausgestaltet sein, auf dessen Drehachse eine Exzenterscheibe eine Bewegung einer mit dem Membranfilter MB bzw. dessen Rahmen verbundenen Schubstange bewirkt. Weiterhin kann der als ein bekannter Elektromagnet ausgestaltete elektromagnetische Wandler bei Anlegen einer Wechselspannung eine Weicheisenmembran, beispielsweise aus dünnem Stahlblech, durch ein magnetisches Feld einer Spule zum Schwingen bringen, die mechanisch mit dem Membranfilter bzw. dessen Rahmen verbunden ist.

Der elektromechanische Wandler ist beispielsweise als ein piezoelektrischer Wandler ausgestaltet. Ein piezoelektrischer Wandler basiert auf dem Prinzip, daß ein piezoelektrischer Kristall, wie beispielsweise Quarz, durch ein Anlegen einer Wechselspannung zum Schwingen angeregt wird. Durch eine mechanische Kopplung kann diese Schwingung auf den Membranfilter MB bzw. dessen Rahmen übertragen werden. Bekannt sind beispielsweise als flache Scheiben verwirklichte piezoelektrische Wandler. Beim Anlegen einer Wechselspannung führt die Scheibe eine mechanische Schwingung derselben Frequenz aus, deren Amplitude und Ausrichtung durch die mechanischen Eigenschaften - Größe, Form, Vorspannung und Halterung - bestimmt werden. Um große mechanische Bewegungen zu erreichen, muß die Piezoscheibe eine geeignete Dimensionierung und Formgebung aufweisen und/oder mit einem mechanischen Aufbau zur Amplitudenverstärkung bzw. Amplitudentransformation versehen werden.

Eine weitere Möglichkeit zur Reinigung des Membranfilters MB ist die Verwendung eines elektrodynamischen Wandlers. Er basiert auf einer Bewegung einer mit Wechselstrom durchflossenen Spule in einem Dauermagnetfeld. Die Spule bewegt sich proportional zu einer angelegten Wechselspannung, da durch die Wechselspannung in der Spule ein magnetisches Kraftfeld entsteht, welches in Verbindung mit dem Dauermagneten eine Bewegung hervorruft. Ist die Spule mechanisch mit einer Membran gekoppelt, so wird die Membran in Schwingung versetzt.

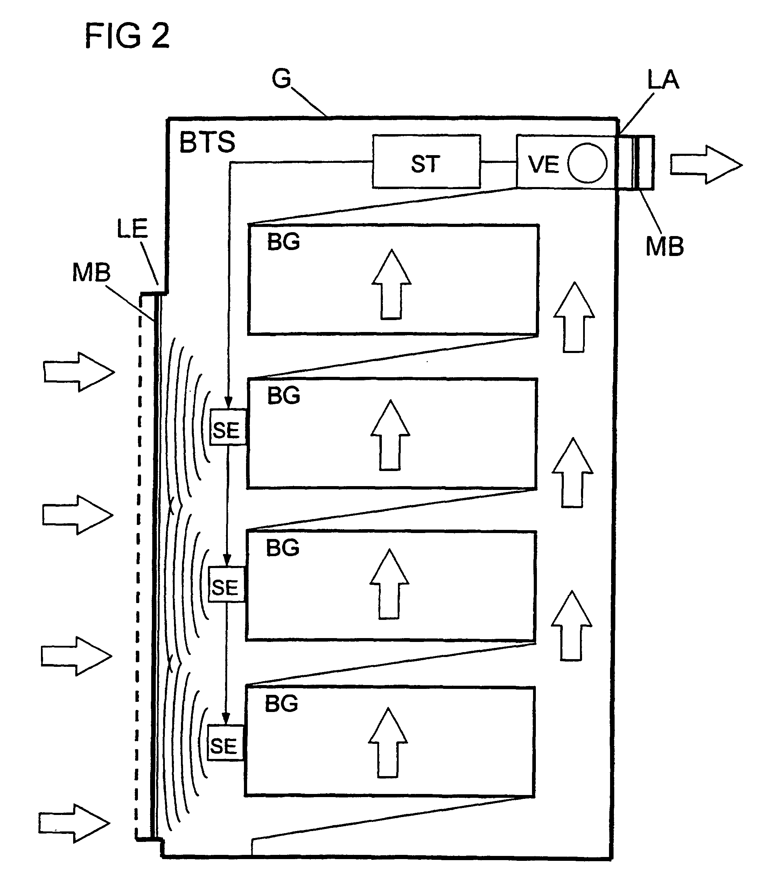

Der beschriebenen Wandler können, wie in der FIG 2 dargestellt, alternativ ebenfalls für eine Erzeugung von Druckwellen benutzt werden, mit denen der Membranfilter MB beaufschlagt wird - die mechanische Kopplung erfolgt hierbei über die Luft. Ein oder mehrere Wandler werden innerhalb des Gehäuses G an der Rückseite des Membranfilters MB angeordnet, wobei die Anordnung vorteilhaft derart erfolgt, daß die gesamte Fläche des Membranfilter MB mit den Druckwellen beaufschlagt wird. Die Druckwellen bewirken eine periodische Druck- und Zugphase in der Schwingungsrichtung.

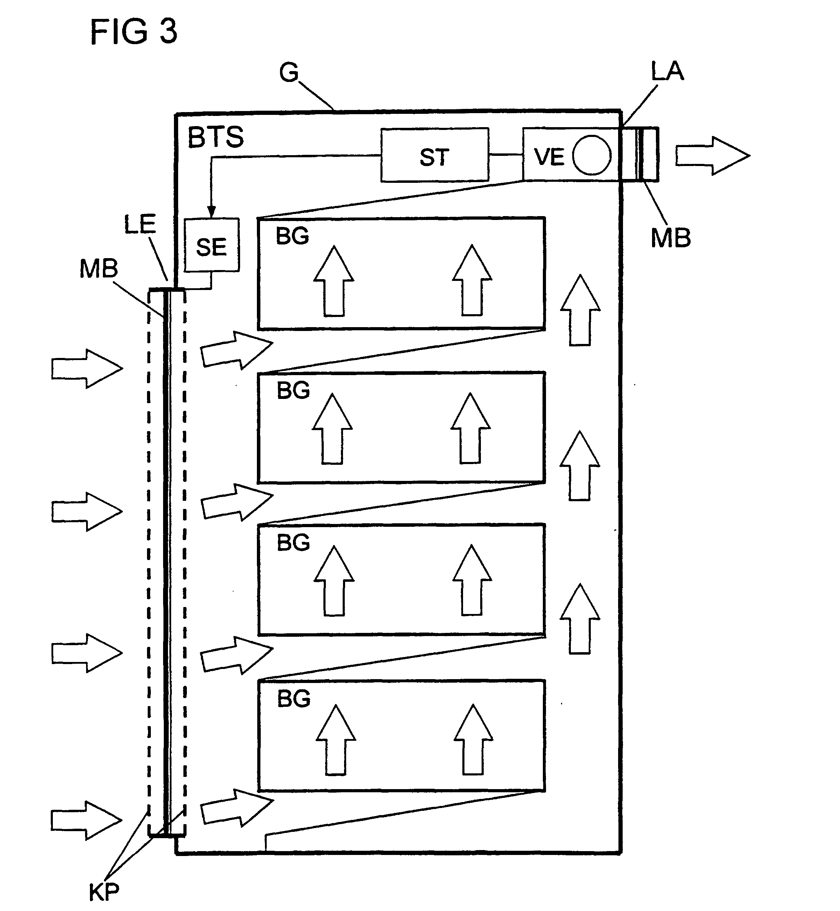

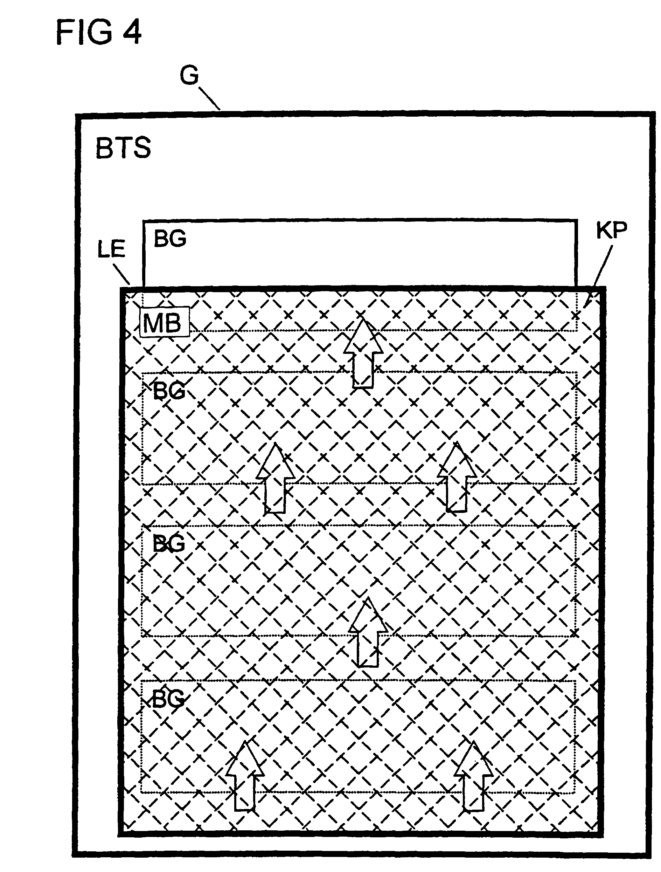

In der FIG 3 ist eine weitere erfindungsgemäße Lösung dargestellt, bei der ein elektrostatischer Wandler für die Erzeugung einer mechanischen Bewegung des Membranfilters MB bzw. dessen Rahmens eingesetzt wird. Der elektrostatische Wandler basiert auf dem Kondensatorprinzip, bei dem die Kraftwirkung eines elektrischen Feldes zwischen zwei Kondensatorplatten KP benutzt wird, um eine elektrisch leitfähige Membran zum Schwingen zu bringen. In der FIG 3 und FIG 4 sind die beiden Kondensatorplatten KP beispielhaft jeweils als ein Geflecht aus einem elektrisch leitfähigen Material, wie beispielsweise Kupfer oder Aluminium, verwirklicht und in einem Abstand zu dem Membranfilter MB angeordnet. Eine beispielsweise gelochte Stahlblechplatte kann in gleicher Weise eingesetzt werden. Wie in der FIG 4 beispielhaft verdeutlicht wird, bewirken die Geflechte keine Einschränkung des Luftdurchsatzes und können vorteilhaft zusätzlich als mechanischer Schutz des Membranfilters MB verwendet werden. Die Kodensatorplatten KP können während des normalen Betriebs des technischen Gerätes für eine elektromagnetische Abschirmung verwendet werden, wobei sie beispielsweise durch den Schwingungserzeuger SE mit Masse oder mit dem Gehäuse G verbunden werden. Für den Reinigungsvorgang werden die Kondensatorplatten KP von der Masse getrennt und der Schwingungserzeuger SE legt eine Spannung an den Kondensatorplatten KP an, die ein wechselndes elektrisches Feld zwischen den Kondensatorplatten KP erzeugt und den Membranfilter MB zum Schwingen anregt.

Alternativ hierzu kann gemäß einer nicht dargestellten Abwandlung der elektrostatische Wandler derart verwirklicht sein, daß der Membranfilter MB ganz oder teilweise aus einem elektrisch leitfähigen Material besteht und als eine Kondensatorplatte KP verwendet wird. Die gegenüberliegende starre Kondensatorplatte KP ist beispielsweise wiederum das Geflecht für die elektromagnetische Abschirmung. Durch eine Veränderung der Ladung der beweglichen Kondensatorplatte KP resp. des Membranfilters MB wird eine Schwingung der Kondensatorplatte KP erzielt.

In allen beschriebenen Fällen wird vorteilhaft eine Schwingung mit der Resonanzfrequenz des Membranfilters MB erzeugt, da diese eine größtmögliche Bewegung des Membranfilters MB hervorruft und somit den Reinigungsvorgang intensiviert. Bei der Beaufschlagung des Membranfilters MB mit Druckwellen kann beispielsweise auch ein bestimmter Phasenversatz zwischen den einzelnen Quellen gewählt werden, so daß die Oberfläche des Membranfilters MB in eine wellenförmige Bewegung versetzt und hierdurch ein schnelleres Loslösen der Schmutzpartikel erreicht wird.

## Patentansprüche

1. Anordnung zum Kühlen einer in einem Gehäuse (G) angeordneten elektrischen Baugruppe (BG), mit zumindest einem in jeweils einem Lufteinlaß (LE) des Gehäuses (G) angeordneten Membranfilter (MB) für eine Oberflächenfilterung von zumindest Schmutzpartikeln aus einströmender Luft zum Kühlen der elektrischen Baugruppe (BG), und zumindest einer Kühleinrichtung (VE) zum Aufbauen einer Luftströmung in dem Gehäuse (G) und zum Herausführen der gefilterten, aufgrund eines Durchund/oder Umströmens der Baugruppe (BG) erwärmten Kühlluft aus zumindest einem Luftauslaß (LA) des Gehäuses (G),
**dadurch gekennzeichnet, daß**
der Membranfilter (MB) mittels zumindest eines Schwingungserzeugers (SE) in eine mechanische Schwingung versetzt wird, die ein Ablösen der an der Oberfläche des Membranfilters (MB) abgelagerten Schmutzparktikel bewirkt.

2. Anordnung nach Anspruch 1,
**dadurch gekennzeichnet, daß**
der Membranfilter (MB) zusätzlich Flüssigkeiten an der Oberfläche abscheidet.

3. Anordnung nach Anspruch 1 oder 2,
**dadurch gekennzeichnet, daß**
die erzeugte Schwingung eine Frequenz aufweist, die einer Eigenresonanzfrequenz des Membranfilters (MB) entspricht.

4. Anordnung nach einem der Ansprüche 1 bis 3,
**dadurch gekennzeichnet, daß**
der Schwingungserzeuger (SE) als ein elektrodynamischer Wandler verwirklicht ist, der mechanisch mit dem Membranfilter (MB) verbunden ist.

5. Anordnung nach einem der Ansprüche 1 bis 3,
**dadurch gekennzeichnet, daß**
der Schwingungserzeuger (SE) als ein mechanische Schwingungen erzeugender elektromagnetischer Wandler verwirklicht ist, wobei der Schwingungserzeuger (SE) mechanisch mit dem Membranfilter (MB) verbunden ist.

6. Anordnung nach einem der Ansprüche 1 bis 3,
**dadurch gekennzeichnet, daß**
der Schwingungserzeuger (SE) als ein elektromechanischer Wandler verwirklicht ist, der mechanisch mit dem Membranfilter (MB) verbunden ist.

7. Anordnung nach Anspruch 6,
**dadurch gekennzeichnet, daß**
der elektromechanische Wandler als ein piezoelektrischer Wandler verwirklicht ist.

8. Anordnung nach einem vorhergehenden Anspruch,
**dadurch gekennzeichnet, daß**
der Schwingungserzeuger (SE) als ein elektrostatischer Wandler verwirklicht ist, wobei der Membranfilter (MB) aus einem elektrisch leitfähigen Material verwirklicht und zwischen zwei Kondensatorplatten (KP) angeordnet ist, und eine elektrostatische Kraft zwischen den Kondensatorplatten die mechanische Bewegung des Membranfilters (MB) bewirkt.

9. Anordnung nach dem vorhergehenden Anspruch,
**dadurch gekennzeichnet, daß**
die Kondensatorplatten (KP) als ein Geflecht aus einem elektrisch leitfähigen Material verwirklicht sind.

10. Anordnung nach Anspruch 8 oder 9,
**dadurch gekennzeichnet, daß**
der Membranfilter (MB) aus einem elektrisch leitfähigen Material als eine der Kondensatorplatten (KP) verwirklicht ist.

11. Anordnung nach einem vorhergehenden Anspruch,
**dadurch gekennzeichnet, daß**
eine Steuereinrichtung (ST) periodisch und/oder abhängig von einem Verschmutzungsgrad des Membranfilters (MB) den Schwingungserzeuger (SE) ansteuert.

12. Technisches Gerät mit einer Anordnung nach einem vorhergehenden Anspruch.

13. Technisches Gerät nach dem vorherigen Anspruch,
das als eine Basisstation (BTS) eines Mobilfunksystems und/oder eines drahtlosen Teilnehmeranschlußsystems verwirklicht ist.

## Claims

1. Arrangement for cooling an electrical module (BG) arranged in a housing (G), with at least one membrane filter (MB), arranged in an air inlet (LE) of the housing (G) in each case, for a superficial filtering of at least dirt particles from inflowing air for cooling the electrical module (BG), and at least one cooling device (VE) for establishing an air flow in the housing (G) and for discharging the filtered cooling air, heated up on account of flowing through and/or around the module (BG), out of at least one air outlet (LA) of the housing (G), **characterized in that** the membrane filter (MB) is made by means of at least one vibration generator (SE) to undergo a mechanical vibration which causes the dirt particles deposited on the surface of the membrane filter (MB) to be dislodged.

2. Arrangement according to Claim 1, **characterized in that** the membrane filter (MB) additionally separates out liquids at the surface.

3. Arrangement according to Claim 1 or 2, **characterized in that** the generated vibration has a frequency which corresponds to a natural resonant frequency of the membrane filter (MB).

4. Arrangement according to any of Claims 1 to 3, **characterized in that** the vibration generator (SE) is provided in the form of an electrodynamic transducer which is mechanically connected to the membrane filter (MB).

5. Arrangement according to any of Claims 1 to 3, **characterized in that** the vibration generator (SE) is provided in the form of an electromagnetic transducer generating mechanical vibrations, the vibration generator (SE) being mechanically connected to the membrane filter (MB).

6. Arrangement according to any of Claims 1 to 3, **characterized in that** the vibration generator (SE) is provided in the form of an electromechanical transducer which is mechanically connected to the membrane filter (MB).

7. Arrangement according to Claim 6, **characterized in that** the electromechanical transducer is provided in the form of a piezoelectric transducer.

8. Arrangement according to a preceding claim, **characterized in that** the vibration generator (SE) is provided in the form of an electrostatic transducer, the membrane filter (MB) being made from an electrically conductive material and arranged between two capacitor plates (KP), and an electrostatic force between the capacitor plates bringing about the mechanical movement of the membrane filter (MB).

9. Arrangement according to the preceding claim, **characterized in that** the capacitor plates (KP) are provided in the form of a netting of an electrically conductive material.

10. Arrangement according to Claim 8 or 9, **characterized in that** the membrane filter (MB) is made from an electrically conductive material as one of the capacitor plates (KP).

11. Arrangement according to a preceding claim, **characterized in that** a control device (ST) activates the vibration generator (SE) periodically and/or on the basis of a degree of soiling of the membrane filter (MB).

12. Technical appliance with an arrangement according to a preceding claim.

13. Technical appliance according to the preceding claim, which is provided in the form of a base station (BTS) of a mobile radio system and/or a wireless subscriber line system.

## Revendications

1. Système pour refroidir un bloc de composants électriques (BG) disposé dans une enceinte (G) équipé d'au moins un filtre à membrane (MB) disposé dans chaque prise d'air (LE) de l'enceinte (G) pour une filtration de surface d'au moins les particules d'impuretés en provenance de l'air affluant pour refroidir le bloc de composants électriques (BG), et d'au moins un système de refroidissement (VE) pour former un courant d'air dans l'enceinte (G) et pour évacuer d'au moins une sortie d'air (LA) de l'enceinte (G) l'air de refroidissement filtré, réchauffé en raison de sa traversée et/ou de son balayage du bloc de composants (BG), **caractérisé en ce que** le filtre à membrane (MB) est mis à osciller mécaniquement au moyen d'au moins un générateur d'oscillations (SE), ce qui entraîne un détachement des particules d'impuretés déposées à la surface du filtre à membrane (MB).

2. Système selon la revendication 1, **caractérisé en ce que** le filtre à membrane (MB) élimine en plus des liquides à la surface.

3. Système selon la revendication 1 ou 2, **caractérisé en ce que** l'oscillation générée présente une fréquence qui correspond à la fréquence de résonance propre du filtre à membrane (MB).

4. Système selon l'une des revendications 1 à 3, **caractérisé en ce que** le générateur d'oscillations (SE) est réalisé comme un transducteur électrodynamique connecté mécaniquement au filtre à membrane (MB).

5. Système selon l'une des revendications 1 à 3, **caractérisé en ce que** le générateur d'oscillations (SE) est réalisé comme un transducteur électromagnétique générant des oscillations mécaniques, ce même générateur d'oscillations (SE) étant connecté mécaniquement au filtre à membrane (MB).

6. Système selon l'une des revendications 1 à 3, **caractérisé en ce que** le générateur d'oscillations (SE) est réalisé comme un transducteur électromécanique connecté mécaniquement au filtre à membrane (MB).

7. Système selon la revendication 6, **caractérisé en ce que** le transducteur électromécanique est réalisé comme un transducteur piézoélectrique.

8. Système selon l'une des revendications précédentes, **caractérisé en ce que** le générateur d'oscillations (SE) est réalisé comme un transducteur électrostatique, le filtre à membrane (MB) étant réalisé en un matériau électroconducteur et disposé entre deux plaques du condensateur (KP), et une force électrostatique entre les plaques du condensateur entraîne le mouvement mécanique du filtre à membrane (MB).

9. Système selon l'une des revendications précédentes, **caractérisé en ce que** les plaques du condensateur (KP) sont réalisées comme un treillis en un matériau électroconducteur.

10. Système selon la revendication 8 ou 9, **caractérisé en ce que** le filtre à membrane est réalisé comme l'une des plaques du condensateur (KP) en un matériau électroconducteur.

11. Système selon l'une des revendications précédentes, **caractérisé en ce qu'**un dispositif de commande (ST) excite le générateur d'oscillations (SE) périodiquement et/ou en fonction d'un degré d'encrassement du film à membrane (MB).

12. Appareil technique équipé d'un système selon l'une des revendications précédentes.

13. Appareil technique selon la revendication précédente, qui est réalisé comme une station de base (BTS) d'un système de téléphonie mobile et/ou d'un système de connexion d'abonné sans fil.
